# EUROPEAN PATENT SPECIFICATION

(11) **EP 4 063 873 B1**
(45) Date of publication and mention of the grant of the patent: **06.03.2024**
(21) Application number: 19955644.0
(22) Date of filing: 11.12.2019
(51) Int. Cl.: G01R 23/16, H03M 7/30, H03M 1/12, H04B 1/18, H04B 1/16

(54) **SIGNAL ANALYSIS DEVICE, CONTROL CIRCUIT, AND STORAGE MEDIUM**
SIGNALANALYSEVORRICHTUNG, STEUERSCHALTUNG UND SPEICHERMEDIUM
DISPOSITIF D'ANALYSE DE SIGNAL, CIRCUIT DE COMMANDE ET SUPPORT DE STOCKAGE

(43) Date of publication of application: 28.09.2022
(73) Proprietor: MITSUBISHI ELECTRIC CORPORATION, Chiyoda-ku Tokyo 100-8310 (JP)
(72) Inventor: AKIYAMA, Yuji, Tokyo 100-8310 (JP)
(74) Representative: Pfenning, Meinig & Partner mbB
(86) International application number: PCT/JP2019/048529
(87) International publication number: WO 2021/117168

(56) References cited:
- WO-A1-2014/191712
- WO-A1-2014/191712
- US-A1- 2013 278 295
- MISHALI M ET AL: "Blind Multiband Signal Reconstruction: Compressed Sensing for Analog Signals", IEEE TRANSACTIONS ON SIGNAL PROCESSING, IEEE, USA, vol. 57, no. 3, 1 March 2009 (2009-03-01), pages 993-1009, XP011249894, ISSN: 1053-587X

## Description

### Field

The present invention relates to a signal analysis device that analyzes a signal of interest, a control circuit, and a storage medium.

### Background

A multi-coset sampling (MCS) system has a configuration in which a plurality of analog-to-digital converters (ADCs) operating at a sampling rate lower than a Nyquist rate are arranged in parallel, and a delay difference is provided between systems of the ADCs. A method has recently been considered in which a signal is received in an MCS system and from the signal folded in a sub-Nyquist zone, a frequency of an original signal is estimated. With the use of such a method, a broadband signal can be detected and analyzed.

For example, Patent Literature 1 discloses a method in which a digital fractional delay (DFD) process for canceling a delay difference between systems of an MCS system and a time-frequency conversion process are collectively performed in a time domain using a finite impulse response (FIR) filter, and then phase compensation corresponding to each sub-Nyquist zone is performed in a frequency domain. In the method, the frequency of an original signal is estimated by determining from which sub-Nyquist zone the original signal has been folded.

### Citation List

### Patent Literature

Patent Literature 1: WO2014/191712

### Summary

### Technical Problem

However, according to the above-described conventional technique, in order to increase frequency resolution, it is necessary to increase the number of stages of the FIR filters, and thus the circuit scale is significantly increased, which is a problem.

The present invention has been made in view of the above, and an object thereof is to obtain a signal analysis device capable of increasing frequency resolution while preventing a circuit scale from increasing.

### Solution to Problem

In order to solve the above-mentioned problem and achieve the object, a signal analysis device according to the present invention includes: a plurality of time-frequency conversion units each provided corresponding to one of a plurality of sampling sequences to convert a corresponding sampling sequence from a signal in a time domain into a signal in a frequency domain, the plurality of sampling sequences having been subjected to sampling performed at a sampling rate lower than a Nyquist rate from a plurality of signal systems generated by branching a signal of interest, and having received addition of delay times different from each other; signal processing units each provided corresponding to one of the plurality of time-frequency conversion units to collectively perform a phase compensation process corresponding to a sub-Nyquist zone of the sampling sequence that is a signal in a frequency domain output by a corresponding time-frequency conversion unit and a process of canceling phase rotation caused by a delay time difference between the plurality of sampling sequences; and a frequency estimation unit to estimate a frequency of the signal of interest by determining from which sub-Nyquist zone the signal of interest has been folded.

### Advantageous Effects of Invention

The signal analysis device according to the present invention achieves an effect that frequency resolution can be increased while preventing a circuit scale from increasing.

### Brief Description of Drawings

FIG. 1 is a diagram illustrating a configuration of a signal analysis device according to a first embodiment of the present invention.
FIG. 2 is a diagram illustrating a configuration of a signal analysis device according to a second embodiment of the present invention.
FIG. 3 is a diagram illustrating an example of a spectrogram according to a comparative example of the present invention.
FIG. 4 is a diagram illustrating an example of a spectrogram obtained by the signal analysis device illustrated in FIG. 2.
FIG. 5 is a diagram illustrating a configuration of an MCS receiver according to a sixth embodiment of the present invention.
FIG. 6 is a diagram for comparing effects of the first embodiment and a third embodiment of the present invention with those of comparative examples #1 and #2.
FIG. 7 is a diagram for comparing effects of the second embodiment and a fourth embodiment of the present invention with those of comparative examples #1 and #2.
FIG. 8 is a diagram illustrating dedicated hardware for realizing functions of time-frequency conversion units, signal processing units, a frequency estimation unit, and windowing processing units according to each of first to seventh embodiments of the present invention.
FIG. 9 is a diagram illustrating a configuration of a control circuit for realizing the functions of the time-frequency conversion units, the signal processing units, the frequency estimation unit, and the windowing processing units according to each of the first to seventh embodiments of the present invention.

### Description of Embodiments

Hereinafter, a signal analysis device, a control circuit, and a storage medium according to each embodiment of the present invention will be described in detail with reference to the drawings. The invention is not limited to the embodiments.

### First Embodiment.

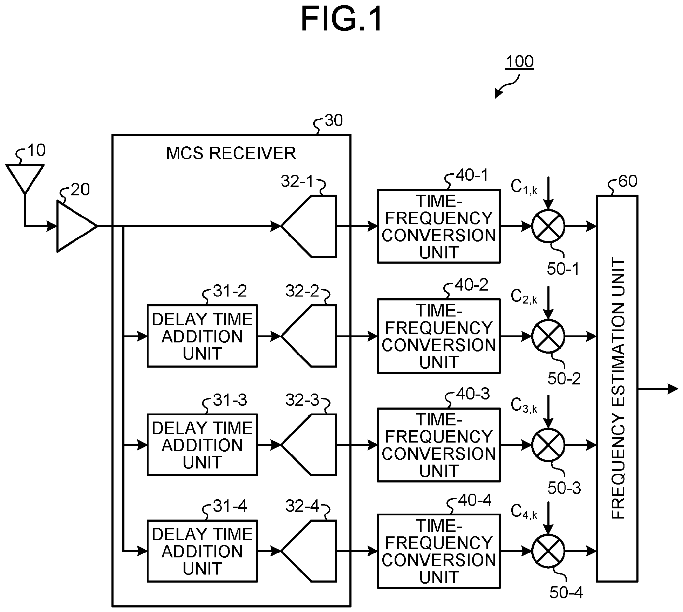

FIG. 1 is a diagram illustrating a configuration of a signal analysis device 100 according to a first embodiment of the present invention. The signal analysis device 100 includes an antenna 10, an amplifier 20, an MCS receiver 30, time-frequency conversion units 40-1 to 40-4, signal processing units 50-1 to 50-4, and a frequency estimation unit 60. The MCS receiver 30 includes delay time addition units 31-2 to 31-4 and sampling units 32-1 to 32-4.

Hereinafter, in a case where it is not necessary to distinguish the delay time addition units 31-2 to 31-4 from each other, each thereof is simply referred to as a delay time addition unit 31, in a case where it is not necessary to distinguish the sampling units 32-1 to 32-4 from each other, each thereof is simply referred to as a sampling unit 32, in a case where it is not necessary to distinguish the time-frequency conversion units 40-1 to 40-4 from each other, each thereof is simply referred to as a time-frequency conversion unit 40, and in a case where it is not necessary to distinguish the signal processing units 50-1 to 50-4 from each other, each thereof is simply referred to as a signal processing unit 50.

When the antenna 10 receives a signal, the signal analysis device 100 outputs the received signal to the amplifier 20. The amplifier 20 amplifies the received signal, and then branches the received signal into a plurality of signal systems. In the example illustrated in FIG. 1, the received signal is branched into four signal systems, i.e., first to fourth signal systems. The first signal system is connected to the sampling unit 32-1. The second signal system is connected to the delay time addition unit 31-2. The third signal system is connected to the delay time addition unit 31-3. The fourth signal system is connected to the delay time addition unit 31-4.

Each of the delay time addition units 31-2 to 31-4 adds a delay time to the corresponding signal system. At that time, the delay times each added by one of the delay time addition units 31-2 to 31-4 have values different from each other. Since the delay time addition unit 31 is not connected to the first signal system, delay times different from each other are added to the first to fourth signal systems. The delay time addition unit 31-2 outputs, to the sampling unit 32-2, the second signal system to which the delay time has been added. The delay time addition unit 31-3 outputs, to the sampling unit 32-3, the third signal system to which the delay time has been added. The delay time addition unit 31-4 outputs, to the sampling unit 32-4, the fourth signal system to which the delay time has been added. Each of the delay time addition units 31-2 to 31-4 can be configured using, for example, a delay element.

Each of the sampling units 32-1 to 32-4 performs sampling from the corresponding signal system to generate a sampling sequence. At that time, each of the sampling units 32-1 to 32-4 uses a sampling rate lower than a Nyquist rate. The sampling unit 32-1 outputs the generated sampling sequence to the time-frequency conversion unit 40-1. The sampling unit 32-2 outputs the generated sampling sequence to the time-frequency conversion unit 40-2. The sampling unit 32-3 outputs the generated sampling sequence to the time-frequency conversion unit 40-3. The sampling unit 32-4 outputs the generated sampling sequence to the time-frequency conversion unit 40-4. Each of the sampling units 32-1 to 32-4 can be configured using, for example, an ADC that converts an analog signal into a digital signal.

With the configuration described above, the MCS receiver 30 generates a plurality of sampling sequences that have been subjected to sampling performed at a sampling rate lower than a Nyquist rate from a plurality of signal systems generated by branching a signal of interest, and have received addition of delay times different from each other.

The time-frequency conversion units 40-1 to 40-4 are provided corresponding to the first to fourth signal systems, respectively, and each convert the corresponding sampling sequence from a signal in a time domain into a signal in a frequency domain. The converted signal is a signal folded in the frequency domain. The time-frequency conversion unit 40-1 outputs the sampling sequence converted into the signal in the frequency domain to the signal processing unit 50-1. The time-frequency conversion unit 40-2 outputs the sampling sequence converted into the signal in the frequency domain to the signal processing unit 50-2. The time-frequency conversion unit 40-3 outputs the sampling sequence converted into the signal in the frequency domain to the signal processing unit 50-3. The time-frequency conversion unit 40-4 outputs the sampling sequence converted into the signal in the frequency domain to the signal processing unit 50-4.

The signal processing units 50-1 to 50-4 are provided corresponding to the plurality of time-frequency conversion units 40-1 to 40-4, respectively, and each perform a signal process of the sampling sequence which is the signal in the frequency domain output by the corresponding time-frequency conversion unit 40. In this signal process, a phase compensation process corresponding to a sub-Nyquist zone of the sampling sequence and a process of canceling phase rotation caused by a delay time difference between the plurality of sampling sequences are collectively performed.

Specifically, the signal processing units 50-1 to 50-4 perform multiplication processes using coefficients C_{1,k} to C_{4,k}, respectively. By multiplying sampling sequences by the coefficients C_{1,k} to C_{4,k}, it is possible to collectively perform the phase compensation process corresponding to respective sub-Nyquist zones of K number of sub-Nyquist folds corresponding to a ratio between a sub-Nyquist rate and a Nyquist rate and the process of canceling the phase rotation due to the delay time difference. Here, a sub-Nyquist zone number k is a number assigned to each of the plurality of sub-Nyquist zones, and takes an integer from 1 to K. In the present embodiment, K is set to 20. Each of the signal processing units 50-1 to 50-4 outputs K multiplication results to the frequency estimation unit 60.

The frequency estimation unit 60 estimates the frequency of the received signal on the basis of the multiplication results output from each of the signal processing units 50-1 to 50-4. Specifically, the frequency estimation unit 60 estimates the frequency of the received signal by calculating the sum of the multiplication results for each sub-Nyquist zone number k and estimating that the received signal is folded from a sub-Nyquist zone in which the largest sum is obtained. For example, the frequency estimation unit 60 calculates the sum of multiplication results in a case of k=1, that is, a result obtained by the signal processing unit 50-1 multiplying the sampling sequence by the coefficient C_{1,1}, a result obtained by the signal processing unit 50-2 multiplying the sampling sequence by the coefficient C_{2,1}, a result obtained by the signal processing unit 50-3 multiplying the sampling sequence by the coefficient C_{3,1}, and a result obtained by the signal processing unit 50-4 multiplying the sampling sequence by the coefficient C_{4,1}. Regarding each of cases of k=2 to k=K, the frequency estimation unit 60 repeats a process similar to that in the case of k=1 to obtain K sum values. The frequency estimation unit 60 selects a sum having a value largest among the K sum values, estimates that the received signal is folded from a sub-Nyquist zone corresponding to the selected sum, and estimates the frequency of the received signal on the basis of the frequency of the sub-Nyquist zone.

Note that, in the above description, the signal analysis device 100 is a reception device that receives a wireless signal, and the signal to be analyzed is a received signal, but the present embodiment is not limited to such an example. The signal analysis device 100 may be any device that analyzes a signal of interest. The received signal is an example of the signal of interest.

As described above, according to the first embodiment of the present invention, in the signal analysis device 100 that estimates the frequency of a signal of interest, each of the plurality of sampling sequences that have been subjected to sampling performed at a sampling rate lower than a Nyquist rate from the plurality of signal systems generated by branching the signal of interest, and have received addition of delay times different from each other is converted from the signal in the time domain signal into the signal in the frequency domain, and then the phase compensation process and the process of canceling the phase rotation caused by the delay time difference are collectively performed in the frequency domain. Therefore, as compared with a case where the phase compensation process is performed in the time domain, it is possible to increase frequency resolution while preventing a circuit scale from increasing.

### Second Embodiment.

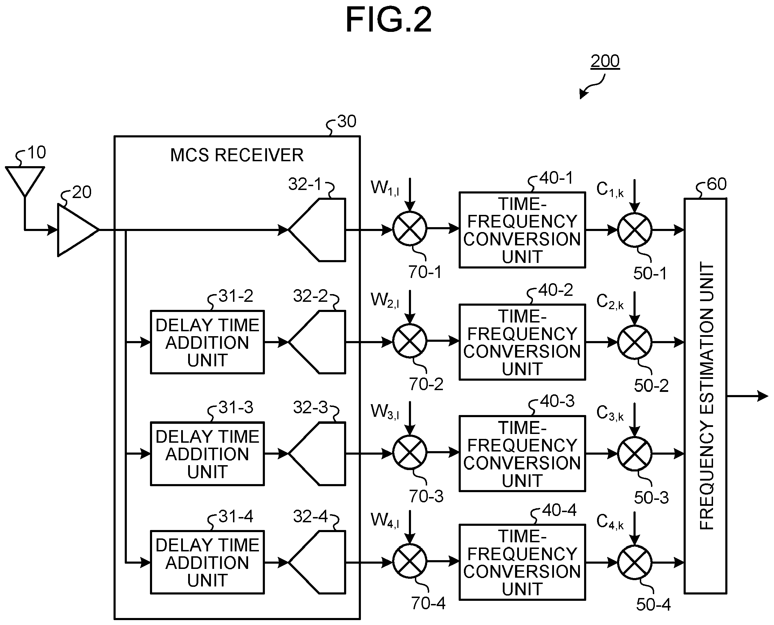

FIG. 2 is a diagram illustrating a configuration of a signal analysis device 200 according to a second embodiment of the present invention. The signal analysis device 200 includes windowing processing units 70-1 to 70-4 between the MCS receiver 30 and the time-frequency conversion units 40-1 to 40-4, respectively, of the signal analysis device 100 illustrated in FIG. 1. Hereinafter, portions different from those of the signal analysis device 100 will be mainly described, and detailed description of functional configurations similar to those of the signal analysis device 100 will be omitted.

The windowing processing units 70-1 to 70-4 are provided corresponding to the sampling units 32-1 to 32-4, respectively. Each of the windowing processing units 70-1 to 70-4 performs a windowing process on the corresponding sampling sequence. The windowing processing units 70-1 to 70-4 are provided at preceding stages of the time-frequency conversion units 40-1 to 40-4, respectively, and signals to be processed by the windowing processing units 70-1 to 70-4 are each a signal in a time domain. The windowing processes performed by the windowing processing units 70-1 to 70-4 are each a process of multiplying a window function. The window function used by the windowing processing units 70-1 to 70-4 only needs to be able to reduce side lobes, and is, for example, a Hann window or a Hamming window. As a condition of a practical window function, a finite length is desirable. In a case where a window function having an infinite length is used, the windowing processing units 70-1 to 70-4 are only required to terminate the calculation at an appropriate length. A value of a signal after the windowing process is zero outside a finite interval.

The windowing processing unit 70-1 is provided at the preceding stage of the time-frequency conversion unit 40-1, and multiplies the sampling sequence which is the signal in the time domain by a coefficient W_{1,1}. The windowing processing unit 70-1 outputs the processed sampling sequence to the time-frequency conversion unit 40-1. The windowing processing unit 70-2 is provided at the preceding stage of the time-frequency conversion unit 40-2, and multiplies the sampling sequence which is the signal in the time domain by a coefficient W_{2,1}. The windowing processing unit 70-2 outputs the processed sampling sequence to the time-frequency conversion unit 40-2. The windowing processing unit 70-3 is provided at the preceding stage of the time-frequency conversion unit 40-3, and multiplies the sampling sequence which is the signal in the time domain by a coefficient W_{3,1}. The windowing processing unit 70-3 outputs the processed sampling sequence to the time-frequency conversion unit 40-3. The windowing processing unit 70-4 is provided at the preceding stage of the time-frequency conversion unit 40-4, and multiplies the sampling sequence which is the signal in the time domain by a coefficient W_{4,1}. The windowing processing unit 70-4 outputs the processed sampling sequence to the time-frequency conversion unit 40-4. The coefficients W_{1,1} W_{2,1}, W_{3,1}, and W_{4,1} are coefficients corresponding to the window function.

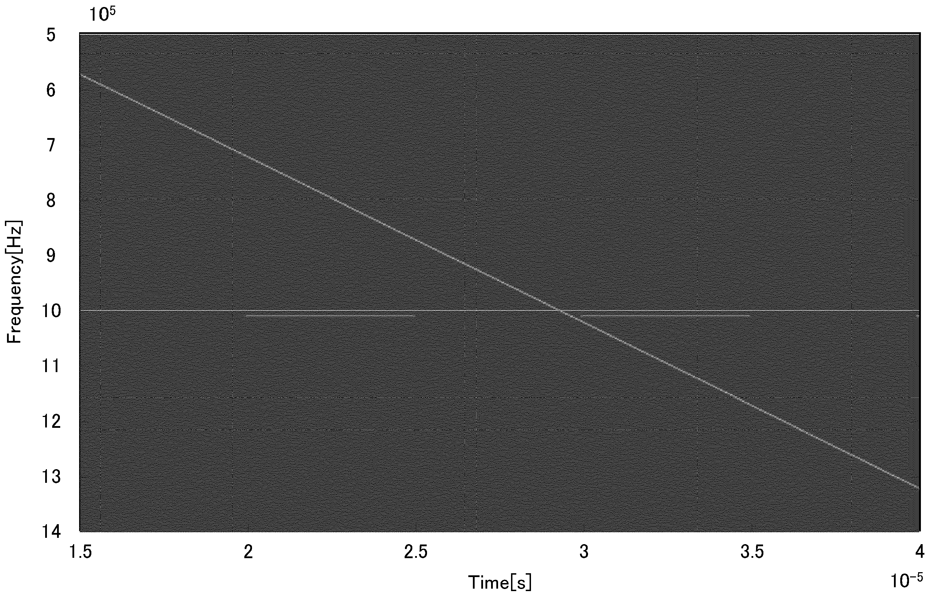

FIG. 3 is a diagram illustrating an example of a spectrogram according to a comparative example of the present invention. The spectrogram illustrated in FIG. 3 is obtained when a signal in which a continuous wave (CW) signal, a pulse signal, and a chirp signal are superimposed is received, and sampling at a sampling rate equal to a Nyquist rate and a signal process by FFT are performed. In FIG. 3, the horizontal axis represents time, the vertical axis represents frequency, and a difference in color density in the graph represents an amplitude absolute value.

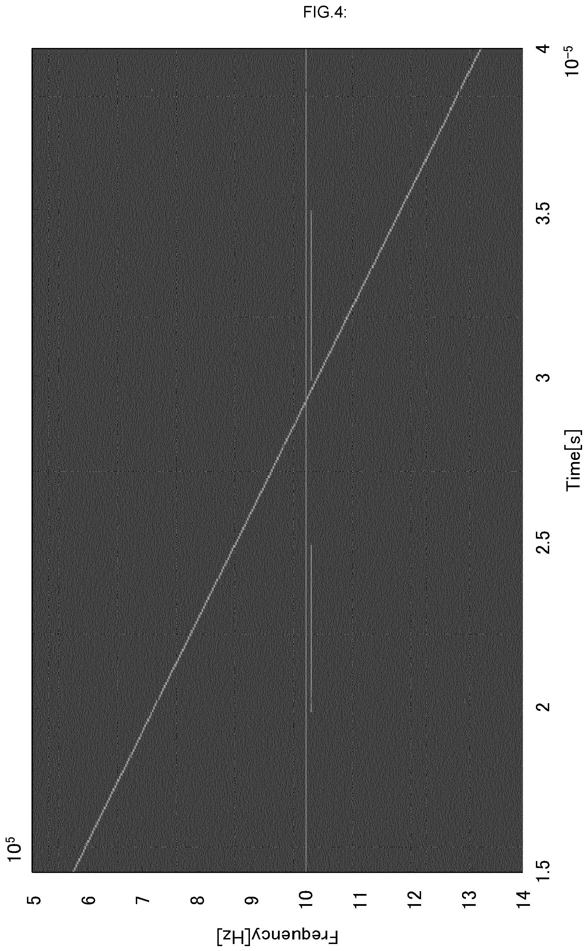

FIG. 4 is a diagram illustrating an example of a spectrogram obtained by the signal analysis device 200 illustrated in FIG. 2. In FIG. 4, the horizontal axis represents time, the vertical axis represents frequency, and a difference in color density in the graph represents an amplitude absolute value. The spectrogram illustrated in FIG. 4 is obtained by the signal analysis device 200 when the same signal as that of the comparative example of FIG. 3 is received. By comparing FIG. 3 with FIG. 4, it can be seen that the spectrogram obtained by the signal analysis device 200 has a high degree of coincidence with the spectrogram obtained in the comparative example in which the sampling at the sampling rate equal to the Nyquist rate and the signal process by FFT have been performed.

As described above, according to the second embodiment of the present invention, in the signal analysis device 200 that estimates the frequency of the signal of interest, the windowing process is performed on the sampling sequence in the preceding stage of each of the time-frequency conversion units 40-1 to 40-4. Therefore, in addition to the effect that "it is possible to increase frequency resolution while preventing a circuit scale from increasing" described in the first embodiment, an effect that side lobes of a spectrogram are reduced and thus a dynamic range can be expanded is achieved.

### Third Embodiment.

A signal analysis device 300 according to a third embodiment of the present invention has a functional configuration similar to that of the signal analysis device 100 according to the first embodiment. Therefore, the functional configuration of the signal analysis device 300 will not be described here in detail, and will be described using reference numerals in FIG. 1. In the signal analysis device 300, the signal processing units 50-1 to 50-4 each perform a signal process limitedly on a sub-Nyquist zone in which a valid signal may be present. The signal analysis device 300 receives electromagnetic waves using the antenna 10. In that case, the fractional bandwidth of the antenna 10 is, for example, only about 0.5, and among the K sub-Nyquist zones, there are a limited number of sub-Nyquist zones in which a valid signal may be present. Therefore, the signal processing units 50-1 to 50-4 can each limit sub-Nyquist zones to be subjected to the signal process depending on the characteristics of the antenna 10.

As described above, according to the third embodiment of the present invention, the signal analysis device 300 having a configuration similar to that in the first embodiment performs the signal process limitedly on a sub-Nyquist zone in which a valid signal may be present among the K sub-Nyquist zones. Therefore, a processing load of the signal process can be reduced. Also in the present embodiment, similarly to the first and second embodiments, it is possible to increase frequency resolution while preventing a circuit scale from increasing.

### Fourth Embodiment.

A signal analysis device 400 according to a fourth embodiment of the present invention has a functional configuration similar to that of the signal analysis device 200 according to the second embodiment. Therefore, the functional configuration of the signal analysis device 400 will not be described here in detail, and will be described using reference numerals in FIG. 2. In the signal analysis device 400, the signal processing units 50-1 to 50-4 each perform a signal process limitedly on a sub-Nyquist zone in which a valid signal may be present. The signal analysis device 400 receives electromagnetic waves using the antenna 10. In that case, the fractional bandwidth of the antenna 10 is, for example, only about 0.5, and among the K sub-Nyquist zones, there are a limited number of sub-Nyquist zones in which a valid signal may be present. Therefore, the signal processing units 50-1 to 50-4 can each limit sub-Nyquist zones to be subjected to the signal process depending on the characteristics of the antenna 10.

As described above, according to the fourth embodiment of the present invention, the signal analysis device 400 having a configuration similar to that in the second embodiment performs the signal process limitedly on a sub-Nyquist zone in which a valid signal may be present among the K sub-Nyquist zones. Therefore, a processing load of the signal process can be reduced. Also in the present embodiment, similarly to the first to third embodiments, it is possible to increase frequency resolution while preventing a circuit scale from increasing.

### Fifth Embodiment.

In the above-described first to fourth embodiments, the delay time addition units 31-2 to 31-4 are each configured using the delay element, but in a fifth embodiment, the delay time addition units 31-2 to 31-4 are each configured using a track-and-hold circuit. Even in the case of using the track-and-hold circuit, a delay time can be added to each signal system similarly to the case of using the delay element. Note that the delay time addition units 31-2 to 31-4 each using the track-and-hold circuit can be applied to any of the configurations of the first to fourth embodiments.

### Sixth Embodiment.

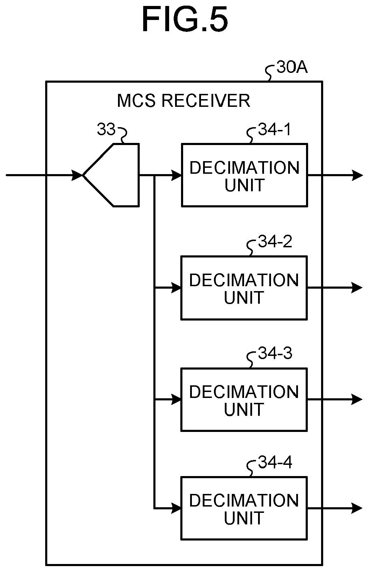

FIG. 5 is a diagram illustrating a configuration of an MCS receiver 30A according to a sixth embodiment of the present invention. In the above-described first to fifth embodiments, the MCS receiver 30 is configured with the sampling units 32-1 to 32-4 and the delay time addition units 31-2 to 31-4 provided at the preceding stages of the sampling units 32-2 to 32-4. On the other hand, in the sixth embodiment, the MCS receiver 30A includes one sampling unit 33 and decimation units 34-1 to 34-4. Hereinafter, in a case where it is not necessary to distinguish the decimation units 34-1 to 34-4 from each other, each thereof is simply referred to as a decimation unit 34.

The sampling unit 33 samples a received signal which is a signal of interest to be input at a sampling rate equal to the Nyquist rate to generate a sampling sequence, branches the generated sampling sequence into four systems, and outputs each of the branched sampling sequences to one of the decimation units 34-1 to 34-4. The sampling unit 33 can be configured using an ADC. The decimation units 34 each decimate the signal from the sampling sequence output by the sampling unit 33, thereby giving different delay times to the respective systems.

With the configuration described above, similarly to the MCS receiver 30, the MCS receiver 30A generates a plurality of sampling sequences that have been subjected to sampling performed at a sampling rate lower than a Nyquist rate from a plurality of signal systems generated by branching a signal of interest, and have received addition of delay times different from each other.

Note that the MCS receiver 30A described here may be used in place of the MCS receiver 30 of the signal analysis device 100 according to the first embodiment, in place of the MCS receiver 30 of the signal analysis device 200 according to the second embodiment, or in place of the MCS receiver 30 of the signal analysis device 300 according to the third embodiment.

### Seventh Embodiment.

In the above-described first to sixth embodiments, the frequency estimation unit 60 has estimated the frequency of the received signal by calculating the sum of the multiplication results for each sub-Nyquist zone number k and estimating that the received signal is folded from a sub-Nyquist zone in which the largest sum is obtained. On the other hand, in a seventh embodiment, the frequency of a received signal is estimated by estimating that the received signal is folded from a sub-Nyquist zone having the smallest variation in the multiplication results for each sub-Nyquist zone number k.

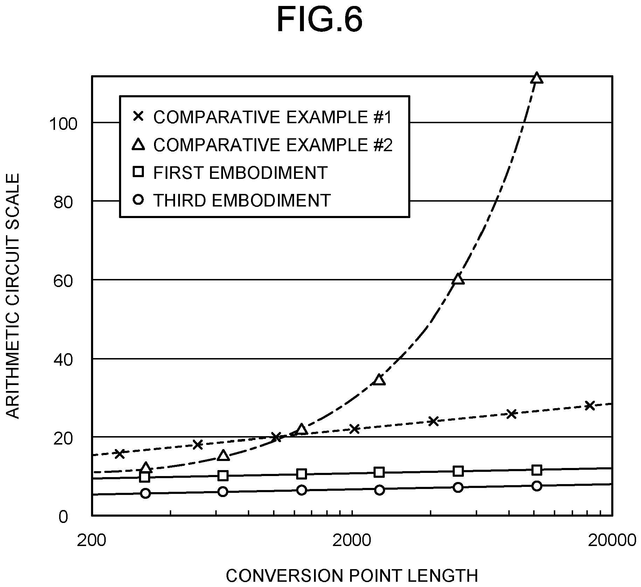

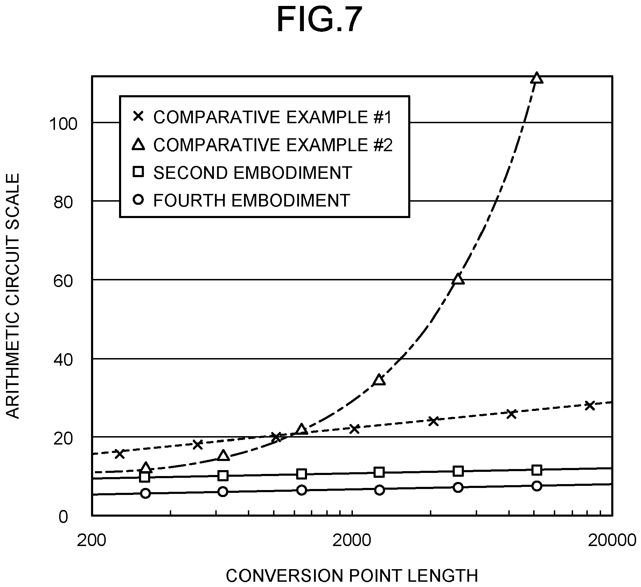

Here, effects of the above-described first to fourth embodiments will be verified. FIG. 6 is a diagram for comparing effects of the first and third embodiments of the present invention with those of comparative examples #1 and #2. FIG. 7 is a diagram for comparing effects of the second and fourth embodiments of the present invention with those of comparative examples #1 and #2.

The horizontal axis in each of FIGS. 6 and 7 represents point length of time-frequency conversion obtained by conversion using a Nyquist rate, and the larger the point length, the higher the frequency resolution. The vertical axis in each of FIGS. 6 and 7 represents arithmetic circuit scale. Regarding comparative example #1 in each of FIGS. 6 and 7, sampling at the Nyquist rate and a signal process by FFT have been performed. Regarding comparative example #2 in each of FIGS. 6 and 7, a signal process using an FIR filter has been performed.

It can be seen from FIGS. 6 and 7 that the arithmetic circuit scale can be reduced as compared with comparative examples #1 and #2 by performing the phase compensation process and the process of canceling the phase rotation in the frequency domain as illustrated in the first to fourth embodiments of the present invention. In particular, when the frequency resolution is increased, it is possible to prevent an increase in the arithmetic circuit scale in the first to fourth embodiments.

In addition, when comparing the first and third embodiments in FIG. 6 with each other, it can be seen that the arithmetic circuit scale is further reduced in the third embodiment. When comparing the second and fourth embodiments in FIG. 7 with each other, it can be seen that the arithmetic circuit scale is further reduced in the fourth embodiment. As a result, it can be seen that by the windowing processes performed in the time domain and the processes performed thereafter by the signal processing units 50, the arithmetic circuit scale can be further reduced.

Next, hardware configurations of the time-frequency conversion units 40, the signal processing units 50, the frequency estimation unit 60, and the windowing processing units 70 according to each of the first to seventh embodiments of the present invention will be described. The time-frequency conversion units 40, the signal processing units 50, the frequency estimation unit 60, and the windowing processing units 70 are realized by processing circuitries. The processing circuitries may be realized by dedicated hardware, or may be each a control circuit using a central processing unit (CPU).

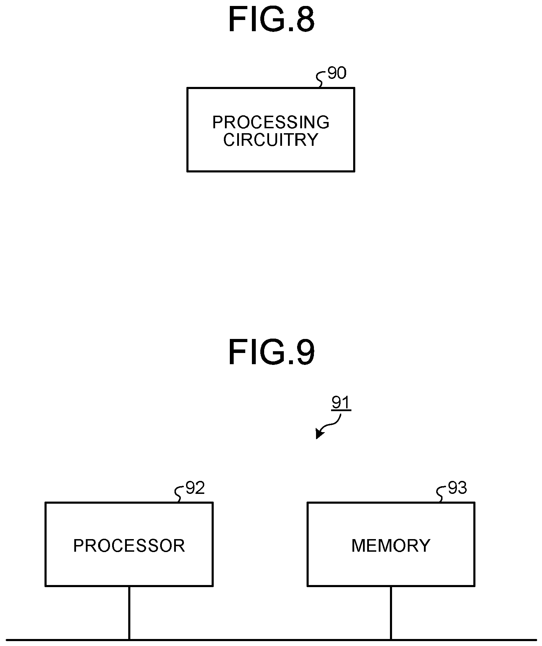

In a case where the above-described processing circuitries are realized by dedicated hardware, these processing circuitries are each realized by a processing circuitry 90 illustrated in FIG. 8. FIG. 8 is a diagram illustrating dedicated hardware for realizing functions of the time-frequency conversion units 40, the signal processing units 50, the frequency estimation unit 60, and the windowing processing units 70 according to each of the first to seventh embodiments of the present invention. The processing circuitry 90 is a single circuit, a composite circuit, a programmed processor, a parallel programmed processor, an application specific integrated circuit (ASIC), a field programmable gate array (FPGA), or a combination thereof.

In a case where the above-described processing circuitries are each realized by a control circuit using a CPU, the control circuit is a control circuit 91 configured as illustrated in FIG. 9, for example. FIG. 9 is a diagram illustrating a configuration of the control circuit 91 for realizing the functions of the time-frequency conversion units 40, the signal processing units 50, the frequency estimation unit 60, and the windowing processing units 70 according to each of the first to seventh embodiments of the present invention. As illustrated in FIG. 9, the control circuit 91 includes a processor 92 and a memory 93. The processor 92 is a CPU, and also referred to as a processing device, an arithmetic device, a microprocessor, a microcomputer, a digital signal processor (DSP), or the like. The memory 93 is, for example, a non-volatile or volatile semiconductor memory such as a random access memory (RAM), a read only memory (ROM), a flash memory, an erasable programmable ROM (EPROM), or an electrically EPROM (EEPROM (registered trademark)), a magnetic disk, a flexible disk, an optical disk, a compact disc, a mini disk, or a digital versatile disk (DVD).

In a case where the above-described processing circuitries are each realized by the control circuit 91, each processing circuitry is realized by the processor 92 reading and executing a program corresponding to a process of each component stored in the memory 93. The memory 93 is also used as a temporary memory in each process executed by the processor 92. The program may be provided via a communication path or may be provided in a state of being stored in a storage medium.

The configurations described in the embodiments above are merely examples of the content of the present invention and can be combined with other known technology, and part thereof can be omitted or modified without departing from the scope of the claims.

### Reference Signs List

10 antenna; 20 amplifier; 30, 30A MCS receiver; 31, 31-2, 31-3, 31-4 delay time addition unit; 32, 32-1 to 32-4, 33 sampling unit; 34, 34-1 to 34-4 decimation unit; 40, 40-1 to 40-4 time-frequency conversion unit; 50, 50-1 to 50-4 signal processing unit; 60 frequency estimation unit; 70-1 to 70-4 windowing processing unit; 90 processing circuitry; 91 control circuit; 92 processor; 93 memory; 100, 200, 300, 400 signal analysis device.

## Claims

1. A signal analysis device (100, 200, 300, 400) comprising:
a plurality of time-frequency conversion units (40-1, 40-2, 40-3, 40-4) each provided corresponding to one of a plurality of sampling sequences to convert a corresponding sampling sequence from a signal in a time domain into a signal in a frequency domain, the plurality of sampling sequences having been subjected to sampling performed at a sampling rate lower than a Nyquist rate from a plurality of signal systems generated by branching a signal of interest, and having received addition of delay times different from each other; **characterized by**
signal processing units (50-1, 50-2, 50-3, 50-4) each provided corresponding to one of the plurality of time-frequency conversion units (40-1, 40-2, 40-3, 40-4) to collectively perform a phase compensation process corresponding to a sub-Nyquist zone of the sampling sequence that is a signal in a frequency domain output by a corresponding time-frequency conversion unit (40) and a process of canceling phase rotation caused by a delay time difference between the plurality of sampling sequences, wherein the signal processing units (50-1, 50-2, 50-3, 50-4) each perform the phase compensation process and the process of canceling phase rotation by multiplying the sampling sequences by coefficients corresponding to respective sub-Nyquist zones of a number of sub-Nyquist folds corresponding to a ratio between a sub-Nyquist rate and a Nyquist rate; and
a frequency estimation unit (60) to estimate a frequency of the signal of interest by determining from which sub-Nyquist zone the signal of interest has been folded.

2. The signal analysis device (200) according to claim 1, further comprising:
windowing processing units (70-1, 70-2, 70-3, 70-4) each provided at a preceding stage of one of the time-frequency conversion units (40-1, 40-2, 40-3, 40-4) to perform a windowing process on a sampling sequence in a time domain.

3. The signal analysis device (300, 400) according to claim 1 or 2, wherein the signal processing units (50-1, 50-2, 50-3, 50-4) each perform the phase compensation process and the process of canceling the phase rotation limitedly on a sub-Nyquist zone in which a valid signal may be present.

4. The signal analysis device (100, 200, 300, 400) according to any one of claims 1 to 3, further comprising delay time addition units (31-2, 31-3, 31-4) to each add a delay time to one of the plurality of signal systems, the delay time addition units (31-2, 31-3, 31-4) being configured with delay elements.

5. The signal analysis device (100, 200, 300, 400) according to any one of claims 1 to 3, further comprising delay time addition units (31-2, 31-3, 31-4) to each add a delay time to one of the plurality of signal systems, the delay time addition units (31-2, 31-3, 31-4) being configured with track-and-hold circuits.

6. The signal analysis device (100, 200, 300, 400) according to any one of claims 1 to 3, further comprising:
an analog-to-digital converter (33) to sample each of the plurality of signal systems at a sampling rate equal to a Nyquist rate; and
decimation units (34-1, 34-2, 34-3, 34-4) to each decimate data from one of the plurality of sampling sequences each sampled from one of the plurality of signal systems to thereby add different delay times for every signal system.

7. The signal analysis device (100, 200, 300, 400) according to claim 1, wherein the frequency estimation unit (60) estimates a frequency of a signal of interest by determining that the signal of interest has been folded from a sub-Nyquist zone in which a largest sum of values is obtained, the values being obtained by the plurality of signal processing units (50-1, 50-2, 50-3, 50-4) each multiplying one of the sampling sequences by one of the coefficients.

8. The signal analysis device (100, 200, 300, 400) according to claim 1, wherein the frequency estimation unit (60) estimates a frequency of a signal of interest by determining that the signal of interest has been folded from a sub-Nyquist zone in which a smallest variation in values is obtained, the values being obtained by the plurality of signal processing units (50-1, 50-2, 50-3, 50-4) each multiplying one of the sampling sequences by one of the coefficients.

## Patentansprüche

1. Signalanalyseeinrichtung (100, 200, 300, 400), umfassend:
eine Vielzahl von Zeit-Frequenz-Wandlereinheiten (40-1, 40-2, 40-3, 40-4), die jeweils entsprechend einer aus einer Vielzahl von Abtastsequenzen vorgesehen sind, um eine entsprechende Abtastsequenz von einem Signal in einer Zeitdomäne in ein Signal in einer Frequenzdomäne umzuwandeln, wobei die Vielzahl von Abtastsequenzen einer Abtastung unterzogen wurden, die mit einer Abtastrate durchgeführt wurde, die niedriger als eine Nyquist-Rate ist, aus einer Vielzahl von Signalsystemen, die durch Verzweigung eines Signals von Interesse erzeugt wurden, und die eine Hinzufügung von voneinander verschiedenen Verzögerungszeiten erhalten haben; **gekennzeichnet durch**
Signalverarbeitungseinheiten (50-1, 50-2, 50-3, 50-4), die jeweils entsprechend einer aus der Vielzahl von Zeit-Frequenz-Wandlereinheiten (40-1, 40-2, 40-3, 40-4) vorgesehen sind, um einen Phasenkompensationsprozess entsprechend einer Unter-Nyquist-Zone der Abtastsequenz, die ein Signal in einer Frequenzdomäne ist, das von einer entsprechenden Zeit-Frequenz-Wandlereinheit (40) ausgegeben wird, und einen Prozess des Aufhebens von Phasendrehung, die durch eine Verzögerungszeitdifferenz zwischen der Vielzahl von Abtastsequenzen verursacht wird, kollektiv durchzuführen, wobei die Signalverarbeitungseinheiten (50-1, 50-2, 50-3, 50-4) jeweils den Phasenkompensationsprozess und den Prozess des Aufhebens von Phasendrehung durchführen, indem die Abtastsequenzen mit Koeffizienten multipliziert werden, die jeweiligen Unter-Nyquist-Zonen einer Anzahl von Unter-Nyquist-Faltungen entsprechen, die einem Verhältnis zwischen einer Unter-Nyquist-Rate und einer Nyquist-Rate entsprechen; und
eine Frequenzschätzungseinheit (60), um eine Frequenz des Signals von Interesse durch Bestimmen, aus welcher Unter-Nyquist-Zone das Signal von Interesse gefaltet wurde, zu schätzen.

2. Signalanalyseeinrichtung (200) nach Anspruch 1, ferner umfassend:
Fensterung-Verarbeitungseinheiten (70-1, 70-2, 70-3, 70-4), die jeweils in einer vorangehenden Stufe einer der Zeit-Frequenz-Wandlereinheiten (40-1, 40-2, 40-3, 40-4) vorgesehen sind, um einen Fensterungsprozess auf eine Abtastsequenz in einer Zeitdomäne durchzuführen.

3. Signalanalyseeinrichtung (300, 400) nach Anspruch 1 oder 2, wobei die Signalverarbeitungseinheiten (50-1, 50-2, 50-3, 50-4) jeweils den Phasenkompensationsprozess und den Prozess des Aufhebens von Phasendrehung begrenzt auf eine Unter-Nyquist-Zone, in welcher ein gültiges Signal vorhanden sein kann, durchführen.

4. Signalanalyseeinrichtung (100, 200, 300, 400) nach einem der Ansprüche 1 bis 3, ferner umfassend Verzögerungszeit-Hinzufügungseinheiten (31-2, 31-3, 31-4), um jeweils eine Verzögerungszeit zu einem aus der Vielzahl von Signalsystemen hinzuzufügen, wobei die Verzögerungszeit-Hinzufügungseinheiten (31-2, 31-3, 31-4) mit Verzögerungselementen konfiguriert sind.

5. Signalanalyseeinrichtung (100, 200, 300, 400) nach einem der Ansprüche 1 bis 3, ferner umfassend Verzögerungszeit-Hinzufügungseinheiten (31-2, 31-3, 31-4), um jeweils eine Verzögerungszeit zu einem aus der Vielzahl von Signalsystemen hinzuzufügen, wobei die Verzögerungszeit-Hinzufügungseinheiten (31-2, 31-3, 31-4) mit Nachlauf- und Halteschaltungen konfiguriert sind.

6. Signalerfassungseinrichtung (100, 200, 300, 400) nach einem der Ansprüche 1 bis 3, ferner umfassend:
einen Analog-Digital-Wandler (33), um jedes der Vielzahl von Signalsystemen mit einer Abtastrate gleich einer Nyquist-Rate abzutasten; und
Dezimationseinheiten (34-1, 34-2, 34-3, 34-4), um jeweils Daten von einer aus der Vielzahl von Abtastsequenzen zu dezimieren, die jeweils von einem aus der Vielzahl von Signalsystemen abgetastet werden, um dadurch unterschiedliche Verzögerungszeiten für jedes Signalsystem hinzuzufügen.

7. Signalanalyseeinrichtung (100, 200, 300, 400) nach Anspruch 1, wobei die Frequenzschätzungseinheit (60) eine Frequenz eines Signals von Interesse schätzt, indem bestimmt wird, dass das Signal von Interesse aus einer Unter-Nyquist-Zone gefaltet wurde, in welcher eine größte Summe von Werten erhalten wird, wobei die Werte durch die Vielzahl von Signalverarbeitungseinheiten (50-1, 50-2, 50-3, 50-4) erhalten werden, die jeweils eine der Abtastsequenzen mit einem der Koeffizienten multiplizieren.

8. Signalanalyseeinrichtung (100, 200, 300, 400) nach Anspruch 1, wobei die Frequenzschätzungseinheit (60) eine Frequenz eines Signals von Interesse schätzt, indem bestimmt wird, dass das Signal von Interesse aus einer Unter-Nyquist-Zone gefaltet wurde, in welcher eine kleinste Variation der Werte erhalten wird, wobei die Werte durch die Vielzahl von Signalverarbeitungseinheiten (50-1, 50-2, 50-3, 50-4) erhalten werden, die jeweils eine der Abtastsequenzen mit einem der Koeffizienten multiplizieren.

## Revendications

1. Dispositif d'analyse de signaux (100, 200, 300, 400), comprenant :
une pluralité d'unités de conversion temps-fréquence (40-1, 40-2, 40-3, 40-4) fournies chacune en correspondance avec l'une d'une pluralité de séquences d'échantillonnage en vue de convertir une séquence d'échantillonnage correspondante d'un signal dans un domaine temporel en un signal dans un domaine fréquentiel, la pluralité de séquences d'échantillonnage ayant été soumise à un échantillonnage mis en oeuvre à un taux d'échantillonnage inférieur à un taux de Nyquist à partir d'une pluralité de systèmes de signaux générés en dérivant un signal d'intérêt, et ayant reçu un ajout de temps de retard différents les uns des autres ; **caractérisé par**
des unités de traitement de signaux (50-1, 50-2, 50-3, 50-4) fournies chacune en correspondance avec l'une de la pluralité d'unités de conversion temps-fréquence (40-1, 40-2, 40-3, 40-4) en vue de mettre collectivement en oeuvre un processus de compensation de phase, correspondant à une zone sub-Nyquist de la séquence d'échantillonnage qui est un signal dans un domaine de fréquence fourni en sortie par une unité de conversion temps-fréquence correspondante (40), et un processus d'annulation d'une rotation de phase causée par une différence de temps de retard entre les séquences de la pluralité de séquences d'échantillonnage, dans lesquelles les unités de traitement de signaux (50-1, 50-2, 50-3, 50-4) mettent chacune en oeuvre le processus de compensation de phase et le processus d'annulation de rotation de phase en multipliant les séquences d'échantillonnage par des coefficients correspondant à des zones sub-Nyquist respectives d'un nombre de plis sub-Nyquist correspondant à un rapport entre un taux sub-Nyquist et un taux de Nyquist ; et
une unité d'estimation de fréquence (60) destinée à estimer une fréquence du signal d'intérêt en déterminant à partir de quelle zone sub-Nyquist le signal d'intérêt a été plié.

2. Dispositif d'analyse de signaux (200) selon la revendication 1, comprenant en outre :
des unités de traitement de fenêtrage (70-1, 70-2, 70-3, 70-4) fournies chacune à un étage précédent de l'une des unités de conversion temps-fréquence (40-1, 40-2, 40-3, 40-4) en vue de mettre en oeuvre un processus de fenêtrage sur une séquence d'échantillonnage dans un domaine temporel.

3. Dispositif d'analyse de signaux (300, 400) selon la revendication 1 ou 2, dans lequel les unités de traitement de signaux (50-1, 50-2, 50-3, 50-4) mettent chacune en oeuvre le processus de compensation de phase et le processus d'annulation de rotation de phase, de manière limitée, sur une zone sub-Nyquist dans laquelle un signal valide peut être présent.

4. Dispositif d'analyse de signaux (100, 200, 300, 400) selon l'une quelconque des revendications 1 à 3, comprenant en outre des unités d'ajout de temps de retard (31-2, 31-3, 31-4) destinées chacune à ajouter un temps de retard à un système de la pluralité de systèmes de signaux, les unités d'ajout de temps de retard (31-2, 31-3, 31-4) étant configurées avec des éléments à retard.

5. Dispositif d'analyse de signaux (100, 200, 300, 400) selon l'une quelconque des revendications 1 à 3, comprenant en outre des unités d'ajout de temps de retard (31-2, 31-3, 31-4) destinées chacune à ajouter un temps de retard à un système de la pluralité de systèmes de signaux, les unités d'ajout de temps de retard (31-2, 31-3, 31-4) étant configurées avec des circuits échantillonneurs bloqueurs.

6. Dispositif d'analyse de signaux (100, 200, 300, 400) selon l'une quelconque des revendications 1 à 3, comprenant en outre :
un convertisseur analogique-numérique (33) destiné à échantillonner chaque système de la pluralité de systèmes de signaux à un taux d'échantillonnage égal à un taux de Nyquist ; et
des unités de décimation (34-1, 34-2, 34-3, 34-4) destinées chacune à décimer des données provenant de l'une des séquences d'échantillonnage, échantillonnées chacune à partir d'un système de la pluralité de systèmes de signaux, afin d'ajouter par conséquent des temps de retard différents pour chaque système de signaux.

7. Dispositif d'analyse de signaux (100, 200, 300, 400) selon la revendication 1, dans lequel l'unité d'estimation de fréquence (60) estime une fréquence d'un signal d'intérêt en déterminant que le signal d'intérêt a été plié à partir d'une zone sub-Nyquist dans laquelle une somme de valeurs la plus élevée est obtenue, les valeurs étant obtenues par la pluralité d'unités de traitement de signaux (50-1, 50-2, 50-3, 50-4) qui chacune multiplient l'une des séquences d'échantillonnage par l'un des coefficients.

8. Dispositif d'analyse de signaux (100, 200, 300, 400) selon la revendication 1, dans lequel l'unité d'estimation de fréquence (60) estime une fréquence d'un signal d'intérêt en déterminant que le signal d'intérêt a été plié à partir d'une zone sub-Nyquist dans laquelle une variation de valeurs la plus faible est obtenue, les valeurs étant obtenues par la pluralité d'unités de traitement de signaux (50-1, 50-2, 50-3, 50-4) qui chacune multiplient l'une des séquences d'échantillonnage par l'un des coefficients.
